**Europäisches Patentamt**

**European Patent Office**

**Office européen des brevets**

(11) Publication number: **0 049 696**
**B1**

(12) ## EUROPEAN PATENT SPECIFICATION

(45) Date of publication of patent specification: **21.01.87**

(21) Application number: **81850160.3**

(22) Date of filing: **18.09.81**

(51) Int. Cl.⁴: **H 03 F 1/52, H 02 H 3/02**

(54) Overvoltage guard for electronic circuits.

(30) Priority: **26.09.80 SE 8006773**

(43) Date of publication of application:
**14.04.82 Bulletin 82/15**

(45) Publication of the grant of the patent:
**21.01.87 Bulletin 87/04**

(84) Designated Contracting States:
**DE FR GB IT**

(56) References cited:
**DE-A-2 950 918**

**ELECTRONICS, vol. 41, November 25, 1968, NEW YORK (US) R. CHAPMAN: UJT protects op amp from voltage transients", blz. 83 BULLETIN DES SCHWEIZERISCHEN ELEKTROTECHNISCHEN VEREINS, vol. 63, no. 2, January 22, 1972, ZÜRICH (CH) J. ISELI: "Empfindlichkeit und Schutz integrierter Schaltkreise gegen Überspannungen", pages 71-77**

(73) Proprietor: **TELEFONAKTIEBOLAGET L M ERICSSON**
**S-126 25 Stockholm (SE)**

(72) Inventor: **Johansson, Jan Hjalmar**
**Vargvägen 18**
**S-198 OO Bälsta (SE)**

(74) Representative: **Johnsson, Helge et al**
**Telefonaktiebolaget L M Ericsson**
**S-126 25 Stockholm (SE)**

(56) References cited:
**ELECTRONIC DESIGN, vol. 19, no. 5, March 4, 1971; ROCHELLE PARK (US) "Do your IC op amps act like fuses?" page 53**

Courier Press, Leamington Spa, England.

## Description

Technical Field

The invention relates to an overvoltage guard for electronic circuits, e.g. in telephone equipment, suitable for being executed with the aid of integrated circuit technology.

Background Art

Depending on the field of use, electronic circuits are more or less subject to overvoltages on their inputs, which are caused by atmospheric discharges, for example. A typical example is the amplifying and signalling circuits in the line circuits for telephone exchanges, where the inputs and outputs can be subjected to overvoltages via the subscriber lines. These circuits are therefore provided with different forms of overvoltage protection which can be incorporated in the circuit itself, or laid outside it depending on the currents which must be led off.

If the electronic circuit is done with the monolithic type of circuit then it can hardly withstand voltages in excess of the supplied voltage. At the same time it is desired that the circuit will cope with signal voltages in the vicinity of the supply voltage. It is therefore desirable that the potential of the input and output connections can vary within the normal voltage range of the source of current supply, but not appreciably outside this range.

A known method of protecting circuits from overvoltages in this way is to make each connection to the supply voltage poles through limiting diodes, which are turned so that they are nonconducting as long as the connection potential falls below the potential of the voltage source plus pole, but exceeds the potential of its minus pole. The connection potential can therefore not exceed the plus pole potential or fall below the minus pole potential by more than one diode voltage drop. One pole of the voltage source is earthed in many cases. In this circuit there will be an overvoltage in relation to earth, which is led off over a diode to the unearthed pole of the voltage source, to give a current which is not taken directly to earth but passes the voltage source.

Depending on the inner impedance of the source, and the wave form of the overvoltage, unpermitted high voltages can therefore occur on the input in spite of the overvoltage guard.

A known possibility of avoiding this is to connect a diode, which is connected to the earthed pole on the voltage source, in parallel with a varistor. The varistor is then dimensioned to lead such overvoltages to earth which cannot be taken away through the other diode and the inner impedance of the voltage source. In another known circuit, the varistor is replaced by the anode-circuit in a thyristor. The thyristor gate is connected through a Zener diode to the earthed pole of the voltage source. When the voltage difference between the connection and the earthed pole is greater than the Zener voltage, the thyristor becomes conducting and the overvoltage is taken to earth. Both varistor and Zener diode must be selected with regard to the supply voltage for the guard to come into operation at the right level.

Electronics, vol. 41, 25 November 1968, page 83, R. Chapman: "UJT protects op amp from transients" describes an overvoltage protection circuit using a unijunction transistor having the emitter-base 1 circuit connected between the incoming line and ground. The properties of a unijunction transistor is such that the emitter diode is back biased by a voltage equal to the stand off ratio multiplied with the base 1 to base 2 voltage. In principle the emitter diode is connected to a voltage divider the branches of which are the intrinsic base 1 to base 2 resistances. The nominal stand off ratio is normally around 0.7 for most unijunctions but is subject to a wide variation from sample to sample. For most industrial types the stand off ratio varies from 0.5 to 0.8 for a given type.

This means that in the known circuit the highest voltage for which the overvoltage protection is triggered is $0.7 \times V_+$ where $V_+$ is the ungrounded supply terminal voltage. With normal variations this means 12—19 volts for different samples which makes a screening necessary.

In addition the trigger circuit and the shorting path is one and the same causing the circuit to act as a Zener diode with the drawbacks described above. The dependence of the breakdown voltage on the source voltage is indirect in that it is "geared down" by the stand off ratio.

Disclosure of Invention

The known circuits with thyristor + Zener diode or varistor, which are described above, are dependent on the supply voltage and therefore cannot be used if variable supply voltage can otherwise be tolerated. Furthermore, both varistors and Zener diodes get a large spread at the knee of the current-voltage curve during manufacture, signifying that the voltage durability of the protected circuit must have sufficient tolerances. The unijunction overvoltage protection circuit has in principle the same drawbacks as the other circuits and the triggering voltage is always lower than the supply voltage.

An overvoltage protection circuit for protecting a signal input on an electronic circuit gets its power supply from a voltage source having one terminal grounded to prevent that the signal input gets a voltage that substantially exceeds the voltage of the ungrounded terminal. The characterized features of the invention is that a normally nonconducting thyristor has its anode, cathode circuit connected between said input and said grounded terminal and has the gate connected to the ungrounded terminal of the voltage source.

Brief Description of Drawing

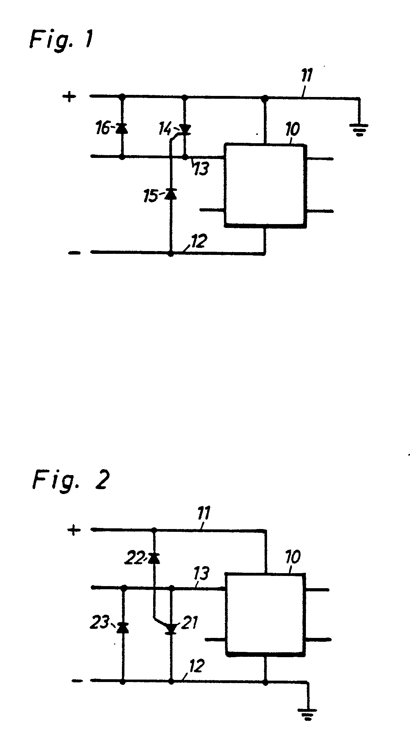

The invention will now be described in detail while referring to the appended drawing, where Figure 1 illustrates a switching arrangement intended as an overvoltage guard in a plus-earthed system, and Figure 2 an equivalent switching arrangement intended for a minus-earthed system.

## Preferred Embodiment

An electric circuit is denoted by the numeral 10 in Figure 1, the circuit comprising, for example, an integrated amplifier intended for connection to a telephone system. The numerals 11 and 12 denote wires, e.g. telephone lines, through which the circuit 11 is supplied with current. The plus wire 11 is earthed in this case, whereas the minus wire can have considerable impedance to earth. The circuit 10 has a plurality of inputs and outputs for signals, of which one such terminal 13 normally has high impedance to the poles of the current source. Between the terminal 13 and the earthed plus pole 11 there is connected a thyristor 14, with forward direction from earth to the terminal 11, there also being a diode 16 with its forward direction from the terminal 13 to earth. The thyristor 14 is provided with a cathode gate which is connected to the minus pole 12 in series with a diode 15, with the forward direction from the minus pole to the cathode gate. The thyristor 14 and diode 16 are normally blocked when the connection has a potential within the plus and minus of the voltage source. The arrangement functions in the following way. If the terminal 13 is subjected to a voltage transient causing the terminal 13 to be more negative than the minus pole of the current source, the diode 15 becomes conductive and the gate of the thyristor 14 gets current. The thyristor 14 continues to be conductive until the voltage of the terminal 13 rises above the level of the minus pole, when the thyristor anode-cathode current path is interrupted. By the thyristor becoming conductive for a voltage which is only some volts under that of the minus pole (a diode voltage drop + the activation voltage of the thyristor) activation to conductivity will be related to the pole voltage of the voltage source the whole time, and the circuit can be used for all supply voltages within the operating range of the connection. A limiting diode 16, preventing the voltage at the terminal 13 exceeding the plus pole voltage, is provided conventionally for overvoltages in the positive direction.

A corresponding switching arrangement is illustrated in Figure 2, for minus-earthed supply. In this case the thyristor 21 is connected between the terminal 13 and the minus pole 12 with its forward direction towards the minus pole. The anode gate on the thyristor 21 is connected to the plus pole 11 in series with the diode 22 with its forward direction to the gate plus pole. The function is entirely equivalent to the one described in Figure 2. As soon as the terminal 13 has a voltage exceeding the plus voltage, the diode 22 and anode-anode gate section in the thyristor 21 become conductive and the thyristor 21 is activated.

In the Figures, the protective circuits 14—16 and 21—23 have been shown situated outside the circuit 10, which in normal cases is a monolithic integrated circuit. In certain cases when the currents which are bypassed are not too high, it is possible to arrange the protective circuits on the same semiconductor wafer. All the other components which are incorporated can then be made in the diffusion processes otherwise normal for the circuit.

## Claims

1. Overvoltage protection circuit for protecting a signal input (13) on an electronic circuit (10) getting its power supply from a voltage source having one terminal (11) grounded to prevent that the signal input (13) gets a voltage that substantially exceeds the voltage of the ungrounded terminal (12) characterized by a normally nonconducting thyristor (14) having its anode-cathode circuit connected between said input (13) and said grounded terminal (11), and having the gate connected to the ungrounded terminal (12) of the voltage source.

2. A switching arrangement as claimed in claim 1, with the plus pole of the current source earthed, characterized in that the cathode gate of the thyristor (14) is connected to the negative pole in series with a diode (15) having its forward direction away from said last-mentioned pole (12).

3. A switching arrangement as claimed in claim 2, with the minus pole of the current source earthed, characterized in that the anode gate of the thyristor (14) is connected to the positive pole in series with a diode (15) having its forward direction towards said last-mentioned pole (11).

## Patentansprüche

1. Überspannungsschutzschaltung zum Schützen eines Signaleingangs (13) auf einer elektronischen Schaltung (10), die ihre Spannungsversorgung von einer Spannungsquelle erhält, deren eine Klemme (11) geerdet ist, um zu verhindern, daß der Signaleingang (13) eine Spannung erhält, welche die Spannung der ungeerdeten Klemme (12) wesentlich übersteigt, gekennzeichnet durch einen normalerweise nichtleitenden Thyristor (14), dessen Anoden-Kathodenkreis zwischen den genannten Eingang (13) und die geerdete Klemme (11) geschaltet ist und dessen Steuerelektrode mit der ungeerdeten Klemme (12) der Spannungsquelle verbunden ist.

2. Schaltanordnung nach Anspruch 1, mit geerdetem Pluspol der Stromquelle, dadurch gekennzeichnet, daß die Kathodensteuerelektrode des Thyristors (14) in Reihe mit einer Diode (15) auf den negativen Pol geschaltet ist, wobei die Durchlaßrichtung der Diode von dem letztgenannten Pol (12) weggerichtet ist.

3. Schaltanordnung nach Anspruch 2, mit geerdetem Minuspol der Stromquelle, dadurch gekennzeichnet, daß die Anodensteuerelektrode des Thyristors (14) in Reihe mit einer Diode (15) auf den positiven Pol geschaltet ist, wobei die Durchlaßrichtung der Diode zu dem letztgenannten Pol (11) hingerichtet ist.

**Revendications**

1. Circuit de protection contre les surtensions destiné à protéger une entrée (13) de signal d'un circuit électronique (10) tirant son énergie d'alimentation d'une source de tension ayant une borne (11) à la masse afin d'empêcher que l'entrée (13) de signal reçoive une tension qui dépasse sensiblement la tension de la borne (12) non à la masse, caractérisé en ce que le circuit anode-cathode d'un thyristor (14), normalement non conducteur, est connecté entre ladite entrée (13) et ladite borne (11) à la masse, et la gâchette est connectée à la borne (12) non à la masse de la source de tension.

2. Agencement de commutation selon la revendication 1, le pôle positif de la source de courant étant à la terre, caractérisé en ce que la gâchette de cathode du thyristor (14) est connectée au pôle négatif en série avec une diode (15) dont le sens passant s'éloigne du dernier pôle cité (12).

3. Agencement de commutation selon la revendication 2, le pôle négatif de la source de courant étant à la terre, caractérisé en ce que la gâchette d'anode du thyristor (14) est connectée au pôle positif en série avec une diode (15) dont le sens passant s'éloigne du dernier pôle cité (11).

*Fig. 1*

*Fig. 2*

1